# EUROPEAN PATENT SPECIFICATION

(11) **EP 3 406 113 B1**
(45) Date of publication and mention of the grant of the patent: **09.09.2020**
(21) Application number: 17729759.5
(22) Date of filing: 11.01.2017
(51) Int. Cl.: H05K 1/16, H05K 3/46, F02B 39/00, F02B 39/16, F04D 27/00, G01P 3/49, H05K 3/10, H05K 3/12, H05K 3/40, H05K 3/00, H05K 3/26

(54) **MANUFACTURING METHOD FOR A SENSING ELEMENT AND SENSOR DEVICE**
HERSTELLUNGSVERFAHREN FÜR EIN MESSGEGENSTAND UND MESSGERÄT
PROCÉDÉ DE FABRICATION POUR UN ÉLÉMENT DE DÉTECTION ET DISPOSITIF DE DÉTECTION

(30) Priority: 20.01.2016 CH 792016
(43) Date of publication of application: 28.11.2018
(73) Proprietor: Jaquet Technology Group AG, 4054 Basel (CH); Fraunhofer-Gesellschaft zur Förderung der angewandten Forschung e.V., 80686 München (DE)
(72) Inventor: TUOR, Andreas, 1018 Lausanne (CH); HIRSCH, Oliver, 79597 Schallbach (DE); IHLE, Martin, 01277 Dresden (DE); ZIESCHE, Steffen, 01159 Dresden (DE)
(74) Representative: Naiu, Radu Mircea
(86) International application number: PCT/CH2017/000005
(87) International publication number: WO 2017/124200

(56) References cited:
- EP-A2- 1 133 218
- WO-A1-2015/027348
- US-A1- 2001 001 406
- US-A1- 2014 204 548

## Description

### Field of the invention

The invention resides in the field of low temperature co-fired ceramics (LTCC) and concerns a method for manufacturing a sensing element comprising at least a passive electrical component, a coil as sensing element, manufactured by the method, a sensor module comprising such a coil, a sensor device for determining a rotational speed of an object and comprising a sensor module, and a turbocharger comprising such a sensor device, according to the respective independent claims.

### Background

The technology of LTCC is known in electronics for manufacturing electronic circuits with multiple layers on the basis of sintered ceramic substrates. Conductor paths, capacitors, coils, etc. can be manufactured by this technology. An advantage of LTCC circuits is the possibility of integrating these passive electric components into a ceramic casing. This is advantageous for example in difficult operating conditions of said circuits, e.g. dirty and hot environments, as the ceramic casing has good thermo-mechanical and protective properties. Because of the low firing temperature of 850°C to 900°C it is possible to use metals with low power dissipation for circuit paths, typically gold or silver, the melting points of which are between 960°C and 1100°C. The low power dissipation reached by using said metals confers outstanding high frequency properties on modules manufactured by LTCC technology.

An LTCC module is a single or multiple layer substrate consisting of one or more layers of a dielectric tape made of a glass ceramics material and called "green sheet" or "green tape". Passive components like coils may be embedded in this substrate or they may be applied on the uppermost layer.

In an example of turbocharger applications coils are used to sense the rotational speed of compressor blades. A turbocharger uses waste energy from the exhaust gas of an automotive engine to drive the intake and compression of fresh air, which is then forced into the automotive engine. This results in the engine burning more fuel and thus producing more power, while less energy is consumed, thereby improving the overall efficiency of the combustion process. A turbocharger typically comprises a turbine wheel and a compressor wheel, which are connected by a common shaft supported on a bearing system. The turbine wheel is driven by the exhaust gas which in turn drives the compressor wheel, the compressor wheel drawing in and compressing ambient air which is then fed into the engine's cylinders. By means of turbocharging the performance level of smaller engines can be increased up to the performance level of bigger engines without turbocharging, with the added benefits of lower fuel consumption and emissions. Consequently, turbochargers are increasingly employed with diesel and gasoline engines in passenger-, commercial-, off-road and sport vehicles.

Determining rotational speed of the compressor wheel of a turbocharger is important for optimizing its efficiency, and for ensuring that a turbocharger and engine stay within their respective safe operational ranges. Today's turbochargers need to operate reliably and continuously with increasingly higher exhaust gas temperatures and compressor inlet temperatures. Modern gasoline and diesel turbochargers have to operate in a much higher under hood temperature environment, with temperatures at the compressor wheel being around 200°C or above. Modern turbocharger compressor wheels are typically constructed from strong, lightweight conductive materials such as aluminum, titanium or magnesium which can tolerate high stresses. Rotational speed of such compressor wheels can be measured, preferably by means of an active eddy current principle, wherein a magnetic field is generated by an oscillating system and a sensing coil is used to detect compressor blades when they pass through the magnetic field in front of the sensor tip.

Nowadays applications for measuring turbocharger speed are technically challenging because impeller/compressor wheels (the target wheels) are typically very thin (a few tenths of a millimeter), in particular for passenger cars, and therefore generate a low signal for the sensor coil to detect. Also the sensing distance/air gap, i.e., the distance between the sensing element (typically a standard flat coil such as a pancake coil) and the target (the blades), varies as the coil is flat, while the interior wall of the turbocharger housing is round/saddle-shaped and the envelope of the impeller/compressor wheel is curved. Consequently, these coils have a relatively large shape in order to be able to gain enough signal that can be processed for computing said rotational speed. However, these applications require small coils in order to be able to fit them into a relatively small sensor tip such that negative side effects, such as hotspots and aerodynamic disturbances, are avoided or at least minimized. Consequently, the coil diameter defines the size of the sensor tip. The size and position of the coil relative to the blades are decisive parameters for attaining accurate measurement results.

To summarize, factors influencing the quality of rotational speed measurement results for turbochargers are amongst others:

### - Thickness of the blades

The thickness of the blades has an influence on the signal shape and amplitude. The thinner the blades are, the more difficult it is to sense them correctly.

### - Material of blades

Materials with low electrical conductivity like titanium influence the signal shape and amplitude, resulting in low sensitivity.

### - Air gap width between the sensor tip and the blades

In order to get more accurate results, the air gap (distance) between the coil in the sensor tip and the passing blades has to be as small as possible. Therefore the dimensions and shape of the coil play a very important role in this respect.

Due to these three main factors the optimization of coil geometry and dimensions has to be taken into account in order to accurately measure speed.

Generally, winding processes are known and used for manufacturing coils. However, such processes only allow manufacturing of coils having simple geometries e.g. pancake coils. Due to their instability such coils may be deformed during an overmoulding process, resulting in an inconstant and aberrant signal processing.

On the one hand, in order to reach an acceptable small size of the coil for applications requiring small coils, the wound coil solution has proved to work but the result is only a compromise between signal quality, signal shape, air gap and size of the sensing element. As a consequence the signal shape and quality are not satisfactory. For said example of turbocharger applications the above solution is practicable, however at the expense of signal quality and shape.

On the other hand it is possible to increase coil size for signal optimization, however at the expense of the other parametric requirements of the speed sensor, thus resulting in a worse form factor of the sensor tip and an unfavorable air gap.

The alternative to wound coil processes is to manufacture coils in a standard, classical ceramic multilayer technology. However, such coils show a rather poor sensorial performance because the usual layer deposition step in combination with the sintering step limits the dimensions of the deposited coil windings. Maximum metallization thicknesses reached with this process are of about 10 to 20 µm. Thicker layers lead to squeezing (potentially resulting in short circuits between the winding), and can also result in warping or cracking of the ceramic during the sintering process. There are also confinements regarding the line/space dimensions. Typical screen-printing results in 200/200 µm dimensions. Small cross sections of the printed conductor lines and large distances (laterally and vertically) between the different metallization layers and wires results in low inductance and high resistance of the coils. Hence, the quality factor of such coils is rather low, resulting in poor sensor performance.

Further current manufacturing approaches include embossing of channels into the ceramic green tape combined with a further filling process by screen printing. The disadvantage of this approach is the limited embossing channel depth (typically below 30 pm) and restricted space (typically greater than 70 µm) of such structures, which results in high resistances of the metallization structures.

The international patent application WO2015027348 discloses a sensor device comprising a sensor housing with a sensor segment, a mounting segment and a connector segment. The sensor segment and the connector segment are arranged on opposite sides of the mounting segment. A sensing element is arranged at the sensor tip of the sensor segment with the expression "sensor tip" referring to that end of the sensor segment which is furthest away from the mounting segment. Furthermore, sensor electronics are arranged inside the sensing segment, the sensor electronics comprising a silicon-on-insulator circuit. The integrated silicon-on-insulator circuit is embedded between flexible or semi-flexible polymer substrates. The sensor electronics may serve for providing input signals to the sensing element and/or to evaluate and/or amplify output signals/measurement signals provided by the sensing element. WO2015027348 also outlines the measurement basics of said rotational speeds. Additionally, the principles of such measurements are known by those persons skilled in the art. Hence, these principles will not be described in the context of this document.

The European patent application EP 1 133 218 A2 relates to a multilayered circuit board and a method for producing the same. The circuit board has dielectric layers with an area where coil 22 is formed. The coil is arranged on five green sheets 100A-100E and is formed by electrodes 22a to 22e and vias 60.

The US patent application US 2014/204548 concerns a substrate with built-in passive elements, e.g. a coil. The coil element is connected to a terminal on each side of the substrate and is embedded in the substrate.

The US patent application US 2001/001406 relates to a method for making transmission lines and buried passive components in green tape. The method involves the steps of embossing a channel or opening in a green tape using an embossing tool and filling the channel or opening by screen-printing.

### Description of the invention

It is an objective of the present invention to improve the manufacturing technology, and with it the manufactured sensing element, to the extent that the above mentioned disadvantages are addressed.

In a first aspect of the invention this objective is solved by a method according to claim 1.

This manufacturing technology allows implementing metallization layers with very small winding interspaces and at the same time large metallization layer thicknesses. Furthermore, minimum distances between neighboring metallization layers are attained.

In a preferred embodiment a step a0) of tempering all used green sheets by removing at least parts of the solvent is carried out.

In a preferred embodiment a step d0) of laser cleaning of green sheet surfaces between the channels filled with metallization paste is carried out.

In a second aspect of the invention the objective is solved by a coil as sensing element manufactured by means of the method according to the first aspect of the invention. The coil extends on two green sheets with metallizations and holes, wherein the metallization of one green sheet is electrically connected with the metallization of the other green sheet by means of at least one electrically conductive through-contact. All metallizations of the two green sheets together with the at least one through-contact form the coil winding.

Advantageously, such coils have comparatively very small dimensions but at the same time virtually all eligible complex geometries for the coils can be realized.

In a third aspect of the invention the objective is solved by a sensor module with a coil manufactured by the method according to the first aspect of the invention. The sensor module comprises further green sheets additionally to the two green sheets of the coil. At least the outermost green sheets of the sensor module do not comprise channels for metallizations and the two green sheets of the coil are arranged between the outermost green sheets of the sensor module.

Advantageously, a sensor module comprising such a coil can also be manufactured with smaller dimensions. Furthermore, by arranging green sheet layers on both sides of the coil to protect the metal (except through-contacts for electrical connection), a much higher robustness and electrical protection with respect to environmental influences such as heat and dirt are attained.

In a fourth aspect of the invention the objective is solved by a sensor device for determining a speed of an electrically conductive object passing in front of the sensor device. The sensor device comprises a sensor housing and a sensor module according to the third aspect of the invention. The sensor module is arranged at an extremity of the sensor housing and faces in a direction of expected passing of the electrically conductive object. The sensor module is connected to sensor electronics for signal processing and data transmission arranged inside the sensor housing.

A sensor device with such a sensor module is advantageously more flexible regarding its positioning with respect to the object to be measured, as the diameter of the sensor tip is very small.

In a fifth aspect of the invention the objective is solved by a turbo charger comprising a casing, a compressor wheel with compressor wheel blades and a sensor device according to the fourth aspect of the invention. The extremity of the sensor device faces the compressor wheel blades.

A turbocharger with such a sensor device profits from the above mentioned advantages, i.e. hotspots are reduced and a bore hole with a very small diameter is possible, such that the turbocharger performance can be increased, and there is less impact on the turbocharger airflow/efficiency ratio.

In embodiments, the compressor wheel blades can be made of a material with high resistivity, like titanium.

The sensor device according to the fourth aspect of the invention is preferably used for turbochargers of vehicles, particularly off-road vehicles or passenger cars or heavy-duty trucks, or for airplane turbines or for current generating turbines or for drilling machines.

As mentioned, the device solutions of the invention are particularly suitable for difficult environments like vehicles subjected to weather, heat and dirt. For example, as turbochargers in passenger vehicles are typically placed in the exhaust close to the engine, they have to withstand high temperatures. This application emphasizes e.g. the advantage of having ceramic layers as heat-resistive protective layers for the coil. Furthermore, the more accurate measurements and sensitivity of the sensor make it particularly suitable for applications with thin turbocharger blades and blades made of low conductive materials. Such applications are typically passenger vehicles using small turbochargers rotating at very high speeds, e.g. 300.000 rpm. In such a case thin blades are very advantageous as they have a lower inertia moment, thus making the turbocharger more responsive. Titanium blades account for increased durability of the blades, which is a desired property in view of the fast rotational speeds the blades have to withstand.

### Short description of the figures

Further embodiments, advantages and applications of the invention result from the dependent claims and from the following description by considering the figures. It is shown in:
Fig. 1 a schematized and simplified illustration of certain steps of the method according to the invention,
Fig. 2 a schematized stencil with openings (black marked) used for step c) of the method according to the invention,
Fig. 3 a perspective view of a coil according to the invention,
Fig. 4 a top view of the coil of Fig. 3,
Fig. 5 a side view of the coil of Fig. 4,
Fig. 6 a view of the detail of Fig. 5,
Fig. 7 a view of a structured tile as sintered tile before separation of coils,
Fig. 8 a perspective view of a sensor module according to the invention,
Fig. 9 a top view of the sensor module of Fig. 8 as a transparent illustration,
Fig. 10 a sensor device according to the invention,
Fig. 11 a supporting element of Fig. 10 for sensor electronics, and
Fig. 12 a turbocharger according to the invention with the sensor device of Fig. 10 installed.

In the various figures same references denote same or similar or similarly acting components throughout the figures.

### Ways of carrying out the invention

### General notes

The terms "above", "below" and the like are meant with respect to the environment of the respective component. Therefore, for example a first layer arranged above a second layer is closer to the environment than the second layer.

The term "complex geometry" or "complex geometries" is interpreted for coils in this document as a two-dimensional coil structure which cannot be wound or a three-dimensional coil structure. The patent application WO2015027348 shows examples of complex geometries. Therefore, the present document only describes an exemplary geometry for the purpose of explaining the features of the invention. Other geometries are readily possible.

The term air gap is understood as a distance from a sensor tip to an object to be measured. In this context the distance is understood as being the distance from the sensor tip with the sensor module to the closest point of the object to be measured.

In the context of the present invention a "sensing element" is understood as a general term for a product manufactured by the method according to the invention. A "coil" manufactured by the method according to the invention is the electrical component inside the sensing element. It is noted that the "sensing element" may consist of the coil or it may comprise the coil as said passive electrical component together with additional layers. In other words the method steps can be applied to only manufacturing a coil, e.g. a two-layered coil, but they are equally valid in case additional layers are required which are not part of the passive electrical component (coil). Particularly it is clearly understood that a "sensor module" comprising a "coil" may be manufactured by the method according to the invention in one process of manufacturing the coil and adding additional layers above the coil. The term "sensor module" is to be understood as sensing element comprising additional layers to the electrical component in the context of the present document. A "sensor device" is a device containing the sensing element and also other parts which are not manufactured by the method according to the invention. Therefore, the sensor device may comprise only the coil as sensing element or a sensor module.

The term "under pressure" is understood as subjecting the respective entity to a pressure above atmospheric pressure.

Throughout the document the term "metallization" refers to metallized channels and/or metallized through-holes.

In the following pages the figures will be described.

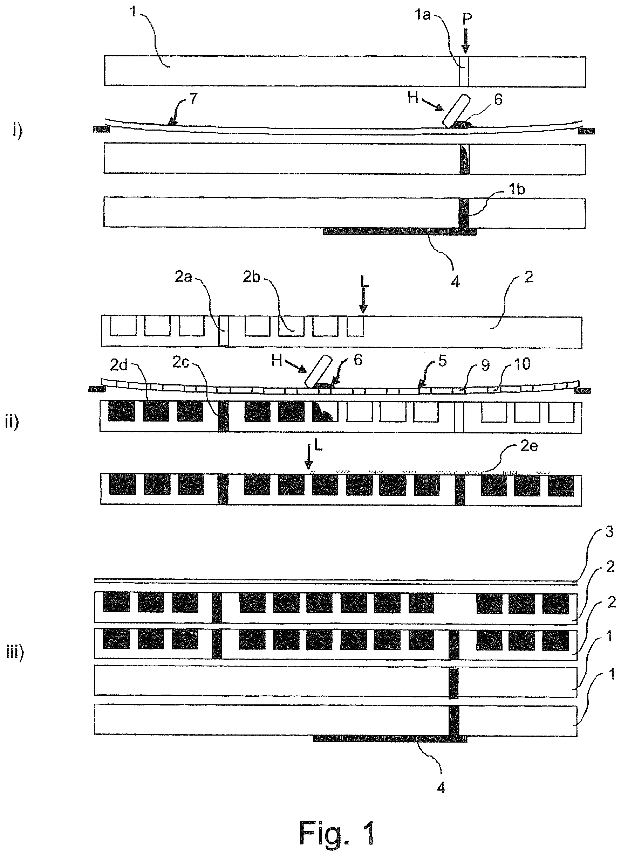

Fig. 1 shows a schematized and simplified illustration of certain steps of the method according to the invention. As mentioned, the method comprises the steps described in the following.

In a first optional step a0) all used green sheets 1, 2, and 3 are tempered by removing at least parts of solvent from them. Those green sheets form an unsintered ceramic entity, i.e. a ceramic plate which has not been otherwise processed by the method. Generally, green sheets are available in different standard dimensions. Tempering the green sheets has a positive effect later during the process, at step c) of stencil printing and drying, and during a second optional step of laser cleaning d0). As the step of drying means exposure of the raw ceramic entity to heat, the layers shrink due to evaporation of solvents. It has been noticed that this shrinkage of green sheets does not take place uniformly throughout its extension but the rate is different at the edges as compared to the middle of the green sheets. This causes undesired deformations of the green sheet surface, which may have an impact on the whole module to be manufactured. By tempering, parts of solvents are extracted from the green sheet, thus yielding later a more uniform, reduced shrinkage of the green sheets.

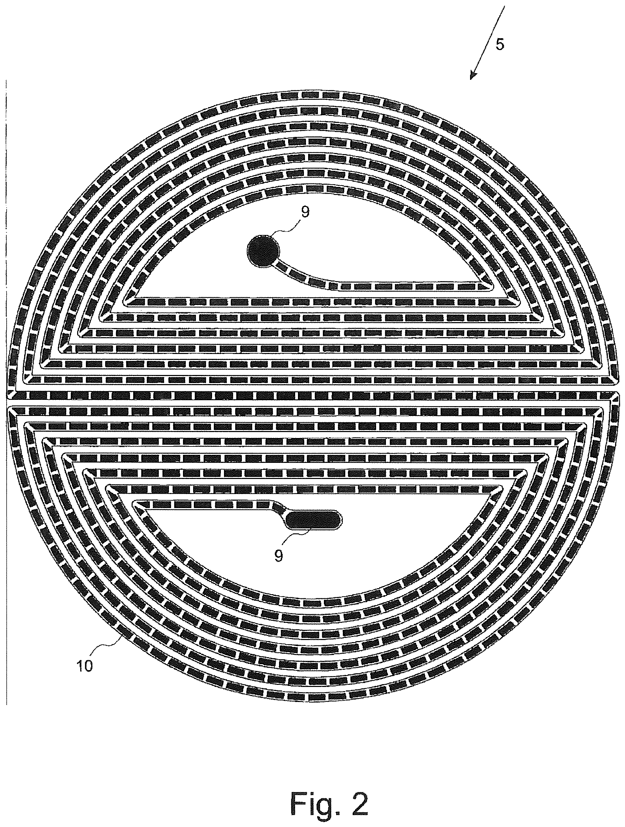

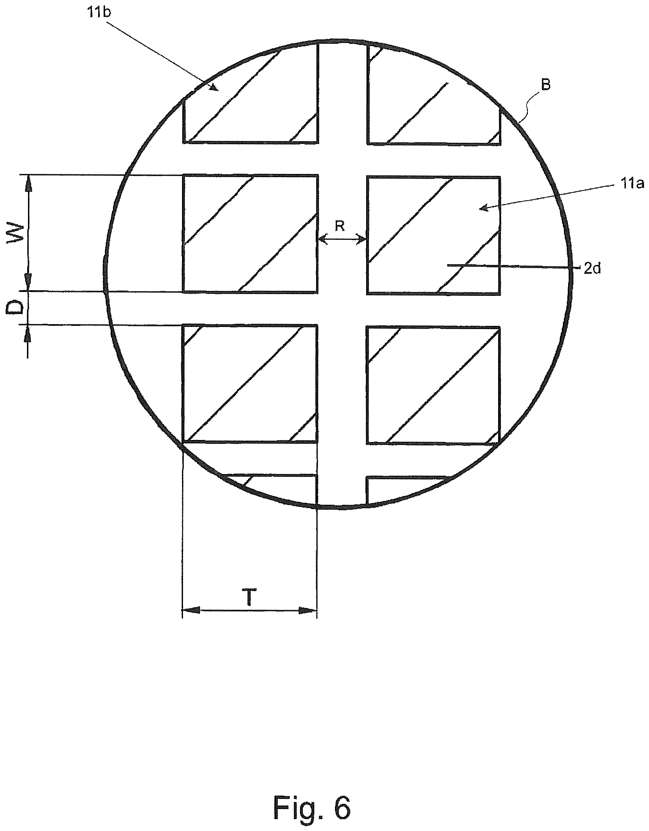

Part i) shows steps a) and c) of green sheets having no channels. In step a) holes 1a (also called via-holes) for through-contacts are punched (P) in the green sheet 1. In step c) they are filled with metallizations resulting in through-contacts 1b. In order to ensure a uniform filling of the holes the printing head (H) must work the metallization paste 6 forward and backward over the stencil. These through-contacts are needed to connect the coil to the pad 4 of the sensor element. Part ii) of the figure corresponds to step b), c) and d0) of green sheets having channels. In step b) channels 2b and through holes 2a are formed by means of lasering (L) in the green sheet 2. They serve for receiving metallizations resulting in filled through holes 2c which form the basis for a connection between the coil and the pad 4, and filled channels 2d. For this lasering it is preferred to use an UV-laser, preferably a suitable, state-of-the-art laser with adequate energy output. Generally, it is preferred to use a high precision laser tool with low geometrical distortion, as the structure to be processed by the laser is very small. This will be described later in connection with Fig. 6. Preferably, step b) of forming channels 2b is carried out gradually in multiple lasering sub-steps until uniform channel depth is obtained. It has been noticed by experiments that using at least three sub-steps, wherein in each sub-step at least a portion of green sheet material is removed in the region for metallization by means of the laser, a uniform channel consistency is achieved without the said step being excessively time consuming. This sub-step-process is preferred due to the small dimensions of the channels in order to avoid a potential "through-lasering" of the entire green sheet. In step c) empty holes 2a and empty channels 2b are filled by stencil printing through a stencil 5 by means of a printing head (H) with metallization paste 6. The stencil will be described in more detail in connection with Fig. 2. In the optional step d0) residual metallization paste between neighboring channels is removed by a laser (L).

In the present example multiple layers are used. In case of manufacturing a sensor module comprising a plurality of green sheets 1, 2 and 3, a step of stacking the green sheets (as shown in Fig. 1 iii) one above the other and aligning them to one another is carried out after the optional step d0) of laser cleaning in order to form the raw ceramic entity.

The step of adding the thin additional green sheet 3 without metallization as outermost green sheet is carried out before sintering the raw ceramic entity in order to protect the electrical passive component or the electrical circuit "buried" in the inner layers.

In this context it is clearly stated that the shown configuration is only for exemplary purposes. The described method can equally be used for manufacturing single-layer or multiple-layers entities.

In the following channels and holes filled with metallization paste 6 will be referred to by 2d and 2c, respectively, in order to differentiate from empty channels and holes 2b, 2c.

During the optional laser-cleaning of step d0) the residual metallization paste 2e on the surfaces between the filled channels 2d is removed by means of laser (L), wherein the above mentioned UV-laser, particularly the diode-pumped solid state laser, is used for this task due to the same reasons as mentioned in connection with step b). This step gains more importance the higher the level of miniaturization is. For example, in case of inter-channel spaces of 30 µm or below, metallization paste residuals can remain on the surface of the green sheet 2 between two adjacent channels 2d, therefore leading to short-circuits. These metallization paste residuals are removed by the cleaning process, wherein the cleaning time is significantly below one second per coil.

Part iii) shows an exemplary stack of layers, of which outermost layer 3 is a protective layer. The following two layers represent a circuit or a passive electrical component with channels 2d and holes 2c already filled with metallization paste 6. The subsequent two layers show exemplarily optional layers having only filled holes 1b, e.g. for establishing electrical contact to the external sensor electronics. At least two pads 4 are printed on one side of the coil for connection to the sensor electronics. The illustration of iii) shows a stage in which the already prepared layers are ready to be stacked (whereas the gaps between the layers shown in the figures are only for illustrative purposes) and are ready to enter step d).

In step d) the raw ceramic entities are aligned, stacked, laminated and sintered for creating the final tile before separating the single coils. In the standard LTCC-process integrating high amounts of metallization paste 6 into a ceramic layer or multilayer commonly results in warping or in defects during a standard firing process (sintering process). These undesired effects occur due to differences in shrinkage rate and absolute shrinkage of the metallization paste 6 and the dielectric base material of the green sheets. Other reasons are the diffusion of the metal of the metallization paste (e.g. silver) into the ceramic base material of the green sheet, leading to non-uniform shrinkage of the ceramic, and therefore to creation of defects. Due to these reasons the current method uses a constrained sintering process which differs from the standard sintering process (unconstrained sintering). It is preferably carried out under pressure. It has been found that a pressure of around 0.1 MPa to 0.8 MPa is sufficient for good results. Other pressures may however also be applied.

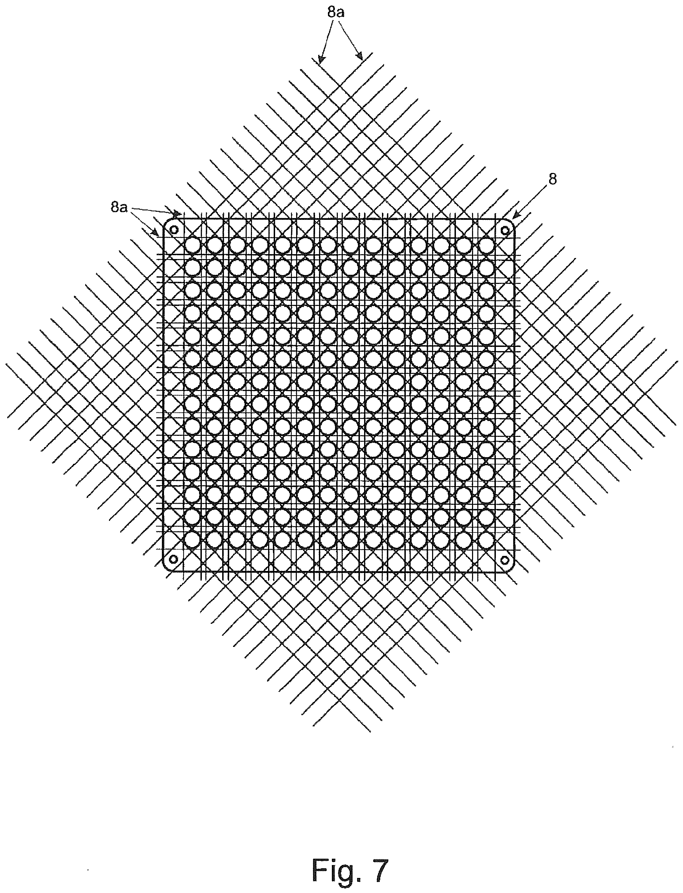

Finally, in a step e) the coils are separated by sawing, laser cutting, or scribing and breaking in order to create the final sensing element. In order to optimize the coil density on the tile and simplify the separation procedure by minimizing the number of sawing or lasering steps, the contour of the sensing entity must be chosen carefully, e.g. an octagon for sawing as described in Fig. 7. In order to simplify this process, alignment marks are printed around each coil.

Fig. 2 shows a stencil 5 used for step c) of the method according to the invention. The stencil 5 comprises openings 10 (for channels 2b) and openings 9 (for holes 2a) such that metallization paste 6 can be introduced into the empty channels 2b and the empty holes 2a via the printing head (H). The equi-spaced openings 10 of the stencil 5 are arranged section-wise along the stencil 5 in order to improve stability of the stencil. Metallization paste 6 pushed into two adjacent openings 10 will also fill channel sections which are covered by stencil material between two adjacent stencil openings 10. The stencil 5 comprises a polymer structure layer for regulating the amount of metallization paste 6 to be filled in the channels 2b and holes 2a. The metallization paste 6 is a conductive paste with a defined solid phase, e.g. silver with solvent. Through holes 2a and channels 2b are filled simultaneously. In order to ensure a uniform filling of the channels with metallization paste 6 the printing head (H) ideally has to be moved forward and backward in several directions in the horizontal plane.

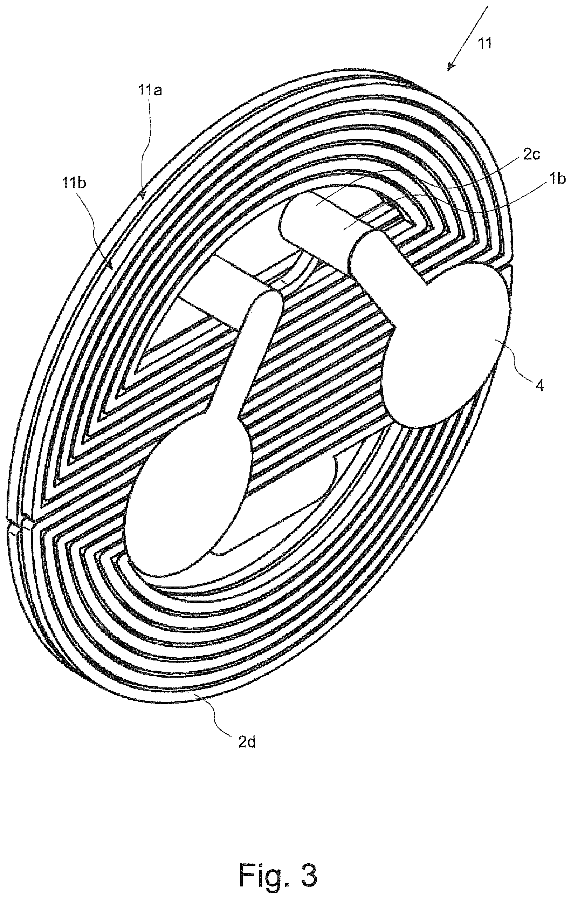

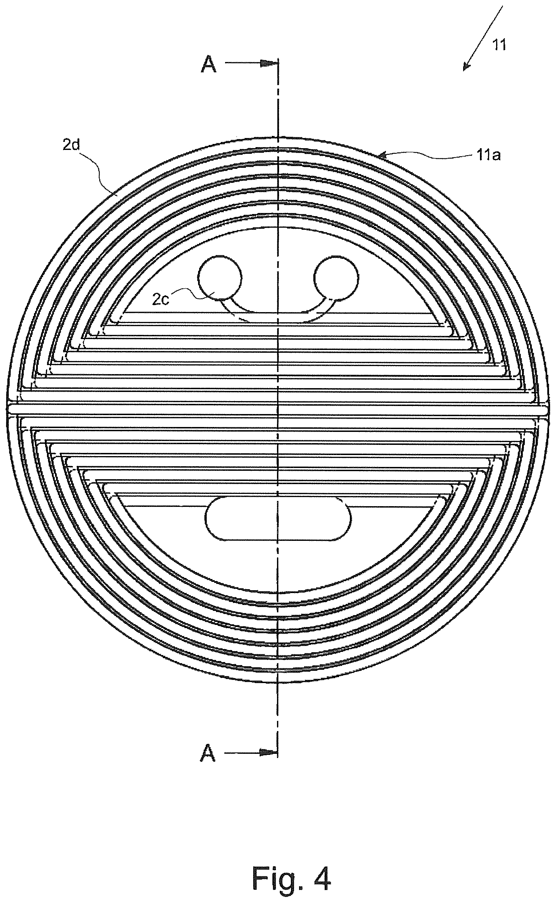

Fig. 3 shows a perspective view of a coil 11 according to the invention and Fig. 4 shows a top view on the coil of Fig. 3. The coil 11 may be regarded as a sensing element 12 manufactured by means of the described method. If additional layers to the coil layer(s) are present, the coil forms the passive electrical component of the sensing element 12. In this particular example the coil 11 consists of two coil layers 11a and 11b corresponding to two green sheets 2 as shown in Fig. 1. For reasons of simplicity only the metallization paths forming the coil winding are shown.

As can be seen in the Fig. 3, contacts 4 for connecting the coil 11 to the sensor electronics are provided, wherein one contact is connected to one end of the winding of the coil 11 and the other contact is connected to the other end of the winding of the coil 11, as known.

In embodiments, the coil is a double-D flat coil or a double-D saddle-shaped coil. However, other coil geometries may readily be manufactured. For example, a coil may be implemented on one single layer or multiple layers, either as a two-dimensional coil or a three-dimensional coil, depending on the required geometry. Examples of coil shapes and more details about such coils can be found in the above mentioned international patent application WO2015027348.

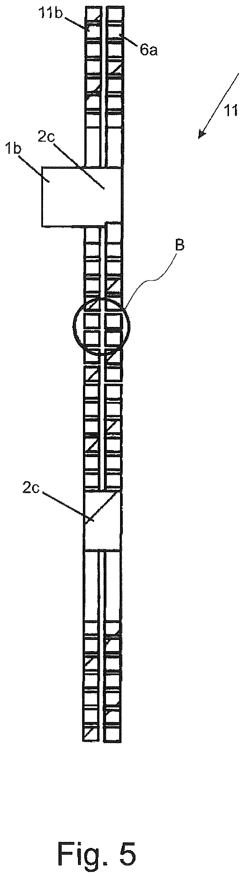

Fig. 5 shows a side view of the coil of Fig. 4 as viewed perpendicularly on the plane AA of Fig. 4 and Fig. 6 shows a cross-section view of the detail B of Fig. 5. As mentioned, the coil is arranged on two green sheet layers.

It is the goal that the metallizations 2d of the coil 11 have an aspect ratio larger than 1. The aspect ratio is defined by depth T of the channel 2d divided by its width W, yielding for the present case T/W > 1.

Particularly, the depth T of each channel 2d ranges between 80 und 120 µm in a non-sintered green sheet with a thickness of 165 µm. The channel depth T depends on the advised metallization thickness and is controlled precisely by lasering steps during the forming process in order to yield uniformly deep channels over the entire structure. This channel depth T predominantly determines the internal resistance of the metallization structure. The residual green sheet thickness R remaining after channel formation (as the case may be during multiple sub-steps of step b) mostly determines the distance between metallization of the different coil layers, and therefore influences the inductivity and capacity of the coil 11.

The width W of each filled channel 11a and 11b for the metallizations is about 70 µm. In embodiments, the distance D between two neighboring filled channels of 11a and 11b (channel interspaces or winding interspaces 2g ranges between 20 und 30 µm.

These dimensions reveal the necessity of using a high precision laser for step b) of forming the channels 2b in the green sheets 2. It also becomes apparent why it may be necessary to use an optional cleaning step d0) in the manufacturing method, as the channel interspaces D are only e.g. 25 µm wide. Without the cleaning step it would be likely that small metallization paste 6 portions could easily bridge this width, thereby creating shortcuts.

Fig. 7 shows an example of a structured tile 8 ready for sawing, laser cutting, or scribing-and-breaking along the separation lines 8a. Four different directions are followed, horizontal, vertical, +45° and -45° in order to obtain an octagonal sensing module 12 containing the sensing element 11.

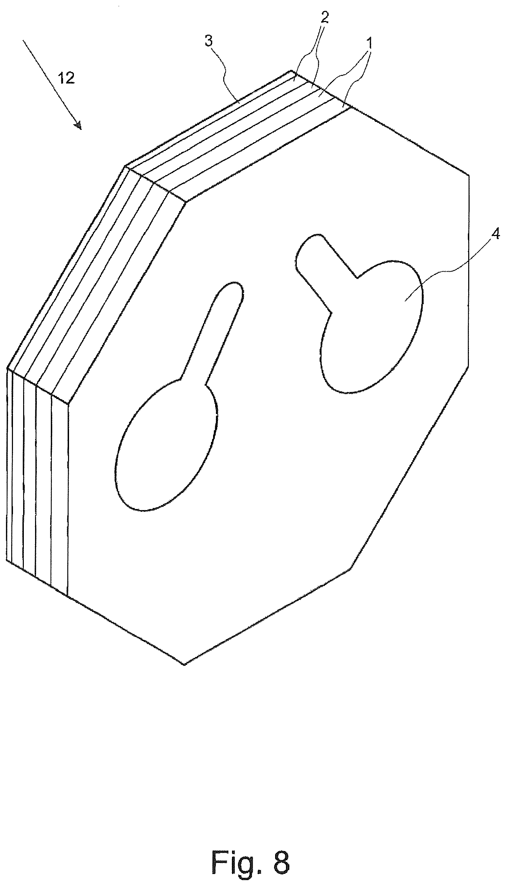

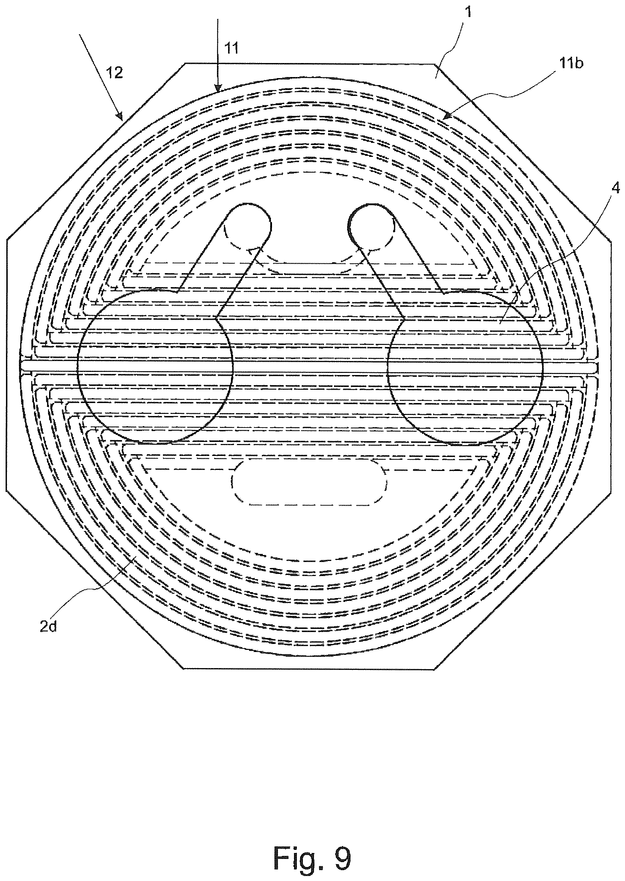

Fig. 8 shows a perspective view of a sensor module 12 according to the invention and Fig. 9 shows a top view of the module of Fig. 8 as transparent illustration. The sensor module 12 comprises a coil 11, visible in Fig. 9 and indicated by the layers 11b. Furthermore, the sensor module 12 comprises further green sheets in addition to the two green sheets 2. Outermost green sheets 3 and two green sheets 1 of the sensor module sandwich in between the (coil layer) two green sheet 2. They are intended for protection of the coil, as mentioned before. Connector holes 1b are provided in green sheet(s) 1. Electrically conductive connector surfaces 4 for the coil 11, used for connecting the sensor module 12 to the sensor electronics, are printed on the outmost green sheet layer 1. This becomes apparent when viewing the connectors 4 in connection with the connector holes 1b of Fig. 3. It is understood that further layers may be arranged between the coil layers 2 and the outermost layer 1.

Preferably, the connector surfaces are arranged on one side of the sensor module 12 in the outermost green sheet 1, as shown in Fig. 8. Therefore, the outermost surface 3 which is not visible in Fig. 8 is a plain green sheet with neither channels nor holes. It is however also possible to arrange one connector surface 4 on one side of the coil 11 and the other connector surface 4 on the other side of the coil 11.

In embodiments, particularly in embodiments related to the application of the sensor module in turbochargers, the sensor module 12 has a minimum diameter of 3 mm, preferably a diameter of 3.7 mm. A maximum diameter is not given as there is no particular restriction on this parameter. The only limitation is given by the application where the sensor module 12 is used and by limitations of the manufacturing process.

The sensor module 12 is manufactured by the described method in the way set forth.

At optional step a0) all green sheets 1, 2 and 3 are tempered.

At step a) green sheets 1 only containing through holes are punched in order to create the through-contacts for electrically connecting the coil 11 to an external circuit. Step a) is not required for the outermost layer 3.

Steps b) and c) and optional step d0) are applied in a similar way to green sheets 2 intended for the coil 11. Steps b) and optional step d0) are not required for layer 1 and steps b) and c) and optional step d0) are not required for layer 3.

Before the sintering of step d), the already mentioned steps of aligning, stacking and lamination of all green sheets is performed. The result is a very compact and robust sensor module. This allows usage of the sensor module in harsh environments.

It is noted that the method according to the invention is carried out for in accordance with the type of layer used. Therefore, suitable controlling procedures and software are used to adapt the method to the particular requirements, e.g. to skip one or more steps for layers which don't require the one or more steps. Furthermore, the said controlling software may trigger repeating of individual steps of the method before subsequent steps are executed, e.g. step b) of forming channels (2b), which is carried out gradually in at least three sub-steps. In embodiments the controlling software may also trigger "parking" green sheets until they are used. For example, if step a0) is carried out for a plurality of layers which include green sheets requiring through-holes and channels and also green sheets not requiring these steps, the latter green sheets may be "parked" until the layers requiring channels and through-holes have been processed according to steps a) to d). Only after this processing the parked green sheets are introduced into the process again for the step e) of stacking, etc. This is preferred such that all layers experience the same shrinkage in a common process step. However it would be possible to process the parked sheets individually, although not preferred.

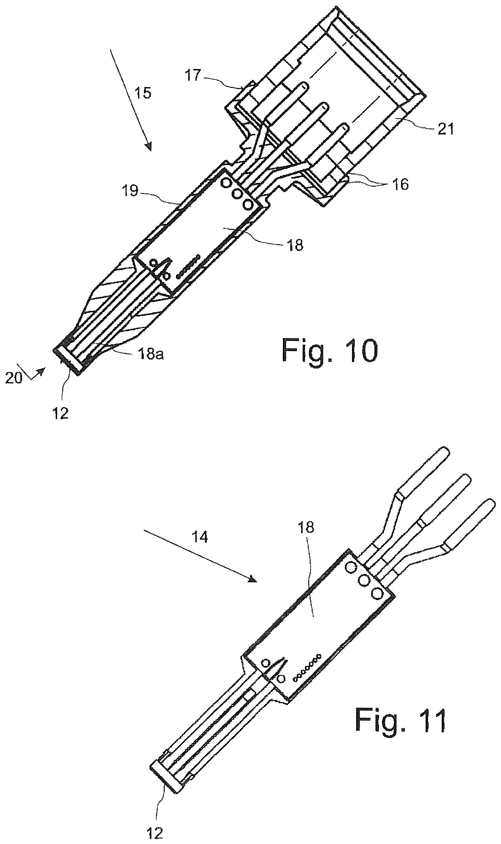

Fig. 10 shows a sensor device 15 according to the invention. The sensor device 15 is preferably used for determining a speed of an electrically conductive object passing in front of the sensor device 15. In the present example the object is a blade 23 of a turbocharger impeller 25 (see Fig. 11). The sensor device 15 comprises a sensor housing 16 and a sensor module 12 arranged at an extremity 20 (sensor tip) of the sensor housing 16 and facing in a direction of expected passing of the electrically conductive object i.e. blade 23. The sensor module 12 is connected to sensor electronics 18 for signal processing and data transmission, arranged inside the sensor housing 16.

The sensor housing 16 further comprises a sensor segment 19, a mounting segment 17 and a connector segment 21 with the mounting segment 17 connecting the sensor segment 19 and the connector segment 21 such they are on opposite sides of the mounting segment 17. The mounting segment 17 is preferably formed as a flange. In particular the sensor module 12 is arranged inside the sensor tip 20 of the sensor segment 19. The sensor module 12 and the sensor electronics 18 are connected to one another by interconnections 18a which are connected to contact pads of the sensor electronics 18 and pads 4 of the sensor module 12. The sensor electronics 18 and the contacts 18a are preferably mounted on a supporting element 14 which defines the correct place of the sensor electronics 18, the contacts 18a and thereby also the sensor module 12.

Fig. 11 shows the supporting element 14 for sensor electronics, which has already been described in the context of Fig. 10.

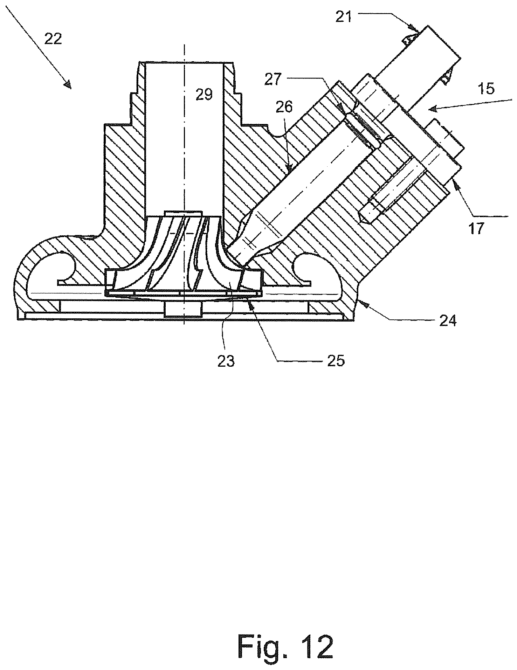

Fig. 12 shows a part of a turbocharger 22 according to the invention with the sensor device 15 of Fig. 10. The turbocharger 22 comprises a casing 24, a compressor wheel 25 with compressor wheel blades 23, particularly made of electrical conductive material, particularly titanium, nickel or aluminum, and a sensor device 15, wherein the sensor tip 20 of the sensor device 15 faces the compressor wheel blades 23. In embodiments, the thickness of the compressor wheel blades 23 is equal to or larger than 0.2 mm.

The turbocharger 22 further comprises a compressor inlet 29 inside the casing 24. The compressor wheel 25 is connected to a turbine wheel by a shaft (not shown). The casing 24 is provided with a recess in form of a hole 26, in particular a cylindrical hole such as a bore hole, that preferably passes entirely through the wall of the turbocharger casing 24 in the direction toward (the blades 23 of) the compressor wheel 25.

The sensor device 15 of the invention is inserted into the cylindrical through-hole 26, which is tapered to accommodate the diameter of the shaft-like sensor segment 19, (but which narrows to a smaller cylindrical diameter at the tip of the sensor device)until its mounting segment 17 abuts on the wall of the turbocharger casing 24 from the outside. The sensor device is fixed to the compressor housing by means of a M4 threaded bolt which is inserted through a hole in the mounting segment 17 and screwed into a corresponding bore mounting in the compressor housing. The connector segment 21 points away from the turbocharger casing 24. The distal end of the sensor segment 19 with the sensor module 12 is located at the inside opening of the cylindrical hole 26 such that the rotating blades 23 pass by it at a short distance.

The outer diameter of the sensor segment 19 basically corresponds to the inner diameter of the cylindrical hole 26 such that the sensor segment 19 tightly fits into the cylindrical hole 26. For secure placement within the cylindrical hole 26 an annular sealing element 27 surrounds the sensor device 15 inside the cylindrical hole 26 to provide a secure and tight fit of the sensor device 15 within the cylindrical bore 26. The annular sealing element 27 is preferably provided at the transition from the sensor segment 19 to the mounting segment 17. The annular sealing element 27 is preferably given by a heat-resistant fluoroelastomer O-ring seal that can withstand temperatures of at least 200°C.

While presently preferred embodiments of the invention are shown and described in this document, it is distinctly understood that the invention is not limited thereto but may be embodied and practiced in other ways within the scope of the following claims. Therefore, terms like "preferred" or "in particular" or "particularly" or "advantageously", etc. signify optional and exemplary embodiments only.

## Claims

1. Method for manufacturing a sensing element (12) comprising at least a passive electrical component omprising a coil (11), comprising the steps of
a) punching holes (1a) for through-contacts in at least one green sheet (1), wherein the through-contacts are part of the passive electrical component (11),
b) forming channels (2b) and through-contacts (2a) by means of lasering at least one green sheet (2) for receiving metallization paste (6), wherein the metallized channels and through-holes (2d, 2c) are part of the coil (11),
c) stencil printing and drying of green sheets (1, 2) including metallization paste (6) in the channels (2b) and holes (1a, 2a) for creating the metallized channels (2d) and metallized through-holes (1b, 2c),
d) aligning, stacking, laminating and sintering all green sheets (1, 2, 3) together for creating a sintered tile (8) comprising coils (11), and
e) separating the individual coils of the sintered tile (8) in order to obtain the finished sensing element 12.

2. Method according to claim 1, wherein before step a) a preliminary step a0) of tempering all used green sheets (1, 2, 3) by removing at least parts of solvent from all those green sheets (1, 2, 3) is carried out.

3. Method according to claim 1 or 2, wherein a step d0) of laser cleaning of surfaces by removal of residual metallization paste (2e) between the metallized channels (2d) is carried out between the steps c) and d).

4. Method according to claim 1 or 2 and claim 3, wherein the step b) of forming channels (2b) and/or the step ii) of removal of residual metallization paste (2e) by laser cleaning of the surface between the metallized channels (2d) is carried out by means of an UV-laser, particularly by means of a diode-pumped solid state laser.

5. Method according to claim 1 or 2, wherein the step b) of forming channels (2b) is carried out gradually in at least three sub-steps until the channels (2b) are entirely formed, particularly in three sub-steps, wherein in each sub-step at least a portion of green sheet material of the channels (2b) is removed by means of laser.

6. Method according to one of the preceding claims, wherein the step c) of stencil printing is carried out by means of a stencil (5) comprising a polymer structure layer for regulating a metallization paste (6) amount to be printed into the channels (2b) and holes (2a), with first openings (10, 9) matching sections of the channels (2b) and/or holes (2a), and a carrier layer as support for the polymer structure layer, with second openings corresponding to the first openings (10, 9) of the polymer structure layer,
wherein the printing is carried out by filling the metallization paste (6) into the channels (2b) and/or the holes (2a) through the openings (9, 10) of the polymer structure layer and the carrier layer.

7. Method according to one of the preceding claims, wherein the sintering of step d) is carried out under pressure, particularly wherein a pressure of around 0.1 MPa to 0.8 MPa is applied.

8. Method according to one of the preceding claims, wherein in case of manufacturing a sensor module (12) comprising a plurality of green sheets (1, 2, 3) a step of aligning and stacking the green sheets (1, 2, 3) is carried out after the step of stencil printing in order to form the raw ceramic entity.

9. Method according to one of the preceding claims, wherein one outermost green sheet (3) has neither metallized channels nor metallized through-holes.

10. Coil (11) as sensing element (12) manufactured by means of the method according to one of the preceding claims, wherein the coil (11) extends on at least one green sheet (2) with metallized channels and metallized through-holes (2c, 2d), wherein one metallized channel and/or at least one metallized through-hole of one green sheet (2) is electrically connected with one metallized channel and/or at least one metallized through-hole of other green sheets (1 and/or 2) or pads (4) by means of at least one electrically conductive through-hole contact (2c or 1b), wherein all metallizations of the green sheets (1 and/or 2), together with at least two pads (4) form the coil (11).

11. Coil according to claim 10, wherein the metallizations of the coil (11) have an aspect ratio larger than 1, particularly wherein a depth (T) of each channel (2b, 2d) ranges between 80 und 120 µm, and a width (W) of each channel (2b, 2d) which is 70 µm in a green sheet (2) of 165 µm thickness.

12. Coil according to claim 10 or 11, wherein a distance (D) between two neighboring channels (2b, 2d) of the coil winding ranges between 20 und 30 µm.

13. Coil according to one of the claims 10 to 12, wherein the coil (11) is a double-D coil or a double-D saddle coil.

14. Sensor module (12) manufactured by the method according to one of the claims 1 to 9, comprising a coil (11) according to one of the claims 10 to 13, wherein the sensor module (12) comprises further green sheets (1, 3) in addition to the two green sheets (2) of the coil (11), wherein outermost green sheet (3) of the sensor module (12) does not comprise metallized channels and/or metallized through-holes and wherein the green sheets (2) of the coil (11) are arranged between the outermost green sheets (1, 3) of the sensor module (12).

15. Sensor module according to claim 14, wherein connector holes (1b, 2c) are provided, particularly wherein the connector holes (1b, 2c) are provided in at least one of the green sheets (1) which do not comprise channels, wherein pads (4) of the coil (11), used for connecting the sensor module (11) to an electrical circuit (18), are arranged in the connector holes (1b, 2c) and each pad (4) is connected to one end of the coil winding by means of through-contacts (1b, 2c).

16. Sensor module according to claim 15, wherein the pads (4) are located on one side of the sensor module (12) on the outermost green sheet (1).

17. Sensor module according to one of the claims 14 to 16, wherein the sensor module (12) has a minimum diameter of 3 mm, particularly a diameter of 3.7 mm.

18. Sensor device (15) for determining the speed of an electrically conductive object (23) passing in front of the sensor device (15), comprising a sensor housing (16), a sensor module (12) according to one of the claims 14 to 17, wherein the sensor module (12) is arranged at a sensor tip (20) of the sensor housing (16) and faces in a direction of expected passing of an electrically conductive object (23), wherein the sensor module (12) is connected to an electrical circuit (18) for signal processing and data transmission arranged inside the sensor housing (16).

19. Turbocharger (22) comprising a casing (24), a compressor wheel (25) with compressor wheel blades (23), particularly made of electrically conductive material, particularly titanium, nickel or aluminium, and a sensor device (15) according to claim 18, wherein the sensor tip (20) of the sensor device (15) faces the compressor wheel blades (23).

20. Turbocharger according to claim 19, wherein the thickness of the compressor wheel blades (23) is equal to or larger than 0.2 mm.

21. Use of the sensor device (15) according to claim 18 as a speed sensor for turbochargers of vehicles, particularly off-road vehicles or passenger cars or heavy-duty trucks, or for airplane turbines or for current generating turbines or for drilling machines.

## Patentansprüche

1. Verfahren zur Herstellung eines Sensorelements (12) umfassend mindestens ein passives elektrisches Bauteil umfassend eine Spule (11), das die folgenden Schritte umfasst
a) Stanzen von Löchern (1a) für Durchgangskontakte in mindestens eine Grünschicht (1), wobei die Durchgangskontakte Teil des passiven elektrischen Bauteils (11) sind,
b) Ausbilden von Kanälen (2b) und Durchgangskontakten (2a) mittels Lasern mindestens einer Grünschicht (2) zur Aufnahme von Metallisierungspaste (6), wobei die metallisierten Kanäle und Durchgangslöcher (2d, 2c) Teil der Spule (11) sind,
c) Schablonendruck und Trocknen von Grünschichten (1, 2) einschliesslich Metallisierungspaste (6) in den Kanälen (2b) und Löchern (1a, 2a) zur Erzeugung der metallisierten Kanäle (2d) und metallisierten Durchgangslöcher (1b, 2c),
d) Ausrichten, Stapeln, Laminieren und Sintern aller Grünschichten (1, 2, 3) zusammen zur Herstellung einer gesinterten Kachel (8) umfassend Spulen (11), und
e) Trennen der einzelnen Spulen der gesinterten Kachel (8), um das fertige Sensorelement 12 zu erhalten.

2. Verfahren nach Anspruch 1, wobei vor Schritt a) ein vorbereitender Schritt a0) des Temperierens aller verwendeten Grünschichten (1, 2, 3) durch Entfernen von mindestens Teilen des Lösungsmittels von allen diesen Grünschichten (1, 2, 3) durchgeführt wird.

3. Verfahren nach Anspruch 1 oder 2, bei dem ein Schritt (d0) einer Laserreinigung von Oberflächen durch Entfernung von Restmetallisierungspaste (2e) zwischen den metallisierten Kanälen (2d) zwischen den Schritten c) und d) durchgeführt wird.

4. Verfahren nach Anspruch 1 oder 2 und Anspruch 3, wobei der Schritt b) des Ausbildens von Kanälen (2b) und/oder der Schritt ii) des Entfernens von Restmetallisierungspaste (2e) durch Laserreinigung der Oberfläche zwischen den metallisierten Kanälen (2d) mittels eines UV-Lasers, insbesondere mittels eines diodengepumpten Festkörperlasers, durchgeführt wird.

5. Verfahren nach Anspruch 1 oder 2, wobei der Schritt b) des Ausbildens von Kanälen (2b) schrittweise in mindestens drei Teilschritten durchgeführt wird, bis die Kanäle (2b) vollständig ausgebildet sind, insbesondere in drei Teilschritten, wobei in jedem Teilschritt mindestens ein Teil des Grünschichtmaterials der Kanäle (2b) mittels Laser entfernt wird.

6. Verfahren nach einem der vorangehenden Ansprüche, bei dem der Schritt c) des Schablonendrucks mittels einer Schablone (5) durchgeführt wird, die eine Polymerstrukturschicht zur Regulierung der Menge einer Metallisierungspaste (6), die in die Kanäle (2b) und Löcher (2a) zu drucken ist, mit ersten Öffnungen (10, 9), die mit Abschnitten der Kanäle (2b) und/oder Löcher (2a) übereinstimmen, und einer Trägerschicht als Träger für die Polymerstrukturschicht aufweist, mit zweiten Öffnungen, die den ersten Öffnungen (10, 9) der Polymerstrukturschicht entsprechen, wobei das Drucken durch Einfüllen der Metallisierungspaste (6) in die Kanäle (2b) und/oder die Löcher (2a) durch die Öffnungen (9, 10) der Polymerstrukturschicht und der Trägerschicht durchgeführt wird.

7. Verfahren nach einem der vorangehenden Ansprüche, wobei das Sintern des Schrittes d) unter Druck durchgeführt wird, insbesondere wobei ein Druck von etwa 0,1 MPa bis 0,8 MPa angewendet wird.

8. Verfahren nach einem der vorangehenden Ansprüche, wobei im Falle der Herstellung eines Sensormoduls (12), das eine Vielzahl von Grünschchten (1, 2, 3) umfasst, ein Schritt des Ausrichtens und Stapelns der Grünschichten (1, 2, 3) nach dem Schritt des Schablonendrucks durchgeführt wird, um die rohe keramische Einheit zu bilden.

9. Verfahren nach einem der vorangehenden Ansprüche, wobei eine äusserste Grünschicht (3) weder metallisierte Kanäle noch metallisierte Durchgangslöcher aufweist.

10. Spule (11) als Sensorelement (12), hergestellt mittels des Verfahrens nach einem der vorangehenden Ansprüche, wobei sich die Spule (11) auf mindestens einer Grünschicht (2) mit metallisierten Kanälen und metallisierten Durchgangslöchern (2c, 2d) erstreckt, wobei ein metallisierter Kanal und/oder mindestens ein metallisiertes Durchgangsloch einer Grünschicht (2) mit einem metallisierten Kanal und/oder mindestens einem metallisierten Durchgangsloch anderer Grünschichten (1 und/oder 2) oder Pads (4) mittels mindestens eines elektrisch leitfähigen Durchgangslochkontakts (2c oder 1b) elektrisch verbunden ist, wobei alle Metallisierungen der Grünschichten (1 und/oder 2) zusammen mit mindestens zwei Pads (4) die Spule (11) bilden.

11. Spule nach Anspruch 10, wobei die Metallisierungen der Spule (11) ein Aspektverhältnis grösser als 1 haben, insbesondere wobei eine Tiefe (T) jedes Kanals (2b, 2d) zwischen 80 und 120 µm liegt und eine Breite (W) jedes Kanals (2b, 2d) 70 µm in einer Grünschicht (2) von 165 µm Dicke beträgt.

12. Spule nach Anspruch 10 oder 11, wobei ein Abstand (D) zwischen zwei benachbarten Kanälen (2b, 2d) der Spulenwicklung zwischen 20 und 30 µm liegt.

13. Spule nach einem der Ansprüche 10 bis 12, wobei die Spule (11) eine Doppel-D-Spule oder eine Doppel-D-Sattelspule ist.

14. Sensormodul (12), hergestellt nach dem Verfahren nach einem der Ansprüche 1 bis 9, umfassend einer Spule (11) nach einem der Ansprüche 10 bis 13, wobei das Sensormodul (12) zusätzlich zu den beiden Grünschichten (2) der Spule (11) weitere Grünschichten (1, 3) umfasst, wobei die äusserste Grünschicht (3) des Sensormoduls (12) keine metallisierten Kanäle und/oder metallisierten Durchgangslöcher aufweist und wobei die Grünschichten (2) der Spule (11) zwischen den äussersten Grünschichten (1, 3) des Sensormoduls (12) angeordnet sind.

15. Sensormodul nach Anspruch 14, wobei Verbindungslöcher (1b, 2c) vorgesehen sind, insbesondere wobei die Verbindungslöcher (1b, 2c) in mindestens einer der Grünschichten (1), die keine Kanäle aufweisen, vorgesehen sind, wobei Pads (4) der Spule (11), die für den Anschluss des Sensormoduls (11) an eine elektrische Schaltung (18) verwendet werden, in den Verbindungslöchern (1b, 2c) angeordnet sind, und jeder Pad (4) mit einem Ende der Spulenwicklung mittels Durchgangskontakten (1b, 2c) verbunden ist.

16. Sensormodul nach Anspruch 15, wobei die Pads (4) auf einer Seite des Sensormoduls (12) auf der äussersten Grünschicht (1) angeordnet sind.

17. Sensormodul nach einem der Ansprüche 14 bis 16, wobei das Sensormodul (12) einen Mindestdurchmesser von 3 mm, insbesondere einen Durchmesser von 3,7 mm, aufweist.

18. Sensorvorrichtung (15) zum Bestimmen der Geschwindigkeit eines elektrisch leitenden Objekts (23), das vor der Sensorvorrichtung (15) vorbeiläuft, umfassend ein Sensorgehäuse (16), ein Sensormodul (12) nach einem der Ansprüche 14 bis 17, wobei das Sensormodul (12) an einer Sensorspitze (20) des Sensorgehäuses (16) angeordnet ist und in eine Richtung des erwarteten Vorbeilaufens eines elektrisch leitenden Objekts (23) weist, wobei das Sensormodul (12) mit einer elektrischen Schaltung (18) zur Signalverarbeitung und Datenübertragung verbunden ist, die innerhalb des Sensorgehäuses (16) angeordnet ist.

19. Turbolader (22) umfassend ein Gehäuse (24), ein Verdichterrad (25) mit Verdichterradschaufeln (23), insbesondere aus elektrisch leitfähigem Material, insbesondere Titan, Nickel oder Aluminium, und einer Sensorvorrichtung (15) nach Anspruch 18, wobei die Sensorspitze (20) der Sensorvorrichtung (15) den Verdichterradschaufeln (23) zugewandt ist.

20. Turbolader nach Anspruch 19, wobei die Dicke der Verdichterradschaufeln (23) gleich oder grösser als 0,2 mm ist.

21. Verwendung der Sensorvorrichtung (15) nach Anspruch 18 als Drehzahlsensor für Turbolader von Kraftfahrzeugen, insbesondere von Gelände- oder Personenkraftwagen oder schweren Lastkraftwagen, oder für Flugzeugturbinen oder für stromerzeugende Turbinen oder für Bohrmaschinen.

## Revendications

1. Procédé de fabrication d'un élément de détection (12) comprenant au moins un composant électrique passif comprenant une bobine (11), comprenant les étapes suivantes :
a) perforer de trous (1a) pour des contacts traversants dans au moins une feuille verte (1), les contacts traversants faisant partie du composant électrique passif (11),
b) former des canaux (2b) et des contacts traversants (2a) au moyen d'un marquage au laser d'au moins une feuille verte (2) destinée à recevoir la pâte de métallisation (6), les canaux métallisés et les trous traversants (2d, 2c) faisant partie de la bobine (11),
c) impression au pochoir et séchage des feuilles vertes (1, 2), y compris la pâte de métallisation (6) dans les canaux (2b) et les trous (1a, 2a) pour créer les canaux métallisés (2d) et les trous métallisés de passage (1b, 2c),
d) aligner, empiler, laminer et fritter toutes les feuilles vertes (1, 2, 3) ensemble pour créer un carreau fritté (8) comprenant des bobines (11), et
e) séparer les bobines individuelles du carreau fritté (8) afin d'obtenir l'élément de détection fini 12.

2. Procédé selon la revendication 1, dans lequel, avant l'étape a), on effectue une étape préliminaire a0) consistant à tempérer toutes les feuilles vertes utilisées (1, 2, 3) en éliminant au moins une partie du solvant de toutes ces feuilles vertes (1, 2, 3).

3. Procédé selon la revendication 1 ou 2, dans lequel une étape d0) de nettoyage au laser des surfaces par élimination de la pâte de métallisation résiduelle (2e) entre les canaux métallisés (2d) est effectuée entre les étapes c) et d).

4. Procédé selon la revendication 1 ou 2 et la revendication 3, dans lequel l'étape b) de formation de canaux (2b) et/ou l'étape ii) d'élimination de la pâte de métallisation résiduelle (2e) par nettoyage au laser de la surface entre les canaux métallisés (2d) est effectuée au moyen d'un laser UV, en particulier au moyen d'un laser à solide pompé par diode.

5. Procédé selon la revendication 1 ou 2, dans lequel l'étape b) de formation des canaux (2b) est réalisée progressivement en au moins trois sous-étapes jusqu'à ce que les canaux (2b) soient entièrement formés, en particulier en trois sous-étapes, dans lequel, dans chaque sous-étape, au moins une partie de la matière en feuille verte des canaux (2b) est enlevée au moyen d'un laser.

6. Procédé selon l'une des revendications précédentes, dans lequel l'étape c) d'impression au pochoir est réalisée au moyen d'un pochoir (5) comprenant une couche de structure polymère pour régler une quantité de pâte de métallisation (6) à imprimer dans les canaux (2b) et les trous (2a), avec des premières ouvertures (10, 9) correspondant à des sections des canaux (2b) et/ou des trous (2a), et une couche de support comme support pour la couche de structure polymère, avec des secondes ouvertures correspondant aux premières ouvertures (10, 9) de la couche de structure polymère, dans lequel l'impression est réalisée en remplissant la pâte de métallisation (6) dans les canaux (2b) et/ou les trous (2a) à travers les ouvertures (9, 10) de la couche de structure polymère et de la couche de support.

7. Procédé selon l'une des revendications précédentes, dans lequel le frittage de l'étape d) est effectué sous pression, en particulier dans lequel une pression d'environ 0,1 MPa à 0,8 MPa est appliquée.

8. Procédé selon l'une des revendications précédentes, dans lequel, dans le cas de la fabrication d'un module de capteur (12) comprenant une pluralité de feuilles vertes (1, 2, 3), une étape d'alignement et d'empilage des feuilles vertes (1, 2, 3) est effectuée après l'étape d'impression au pochoir afin de former l'entité céramique brute.

9. Procédé selon l'une des revendications précédentes, dans lequel une feuille verte (3) située le plus à l'extérieur présente ni des canaux métallisés ni des trous traversants métallisés.

10. Bobine (11) comme élément de détection (12) fabriquée selon le procédé selon l'une des revendications précédentes, dans lequel la bobine (11) s'étend sur au moins une feuille verte (2) avec des canaux métallisés et des trous de passage métallisés (2c, 2d), dans lequel un canal métallisé et/ou au moins un trou de passage métallisé d'une feuille verte (2) est relié électriquement à un canal métallisé et/ou au moins un trou de passage métallisé d'autres feuilles vertes (1 et/ou 2) ou à des plots (4) au moyen d'au moins un contact de trou de passage électriquement conducteur (2c ou 1b), toutes les métallisations des feuilles vertes (1 et/ou 2) formant avec au moins deux plots (4) la bobine (11) .

11. Bobine selon la revendication 10, dans laquelle les métallisations de la bobine (11) ont un rapport d'aspect supérieur à 1, en particulier dans laquelle une profondeur (T) de chaque canal (2b, 2d) est comprise entre 80 et 120 µm, et une largeur (W) de chaque canal (2b, 2d) qui est de 70 µm dans une feuille verte (2) de 165 µm d'épaisseur.

12. Bobine selon la revendication 10 ou 11, dans laquelle une distance (D) entre deux canaux voisins (2b, 2d) de l'enroulement de la bobine est comprise entre 20 et 30 µm.

13. Bobine selon l'une des revendications 10 à 12, dans laquelle la bobine (11) est une bobine double D ou une bobine en selle double D.

14. Module de capteur (12) fabriqué par le procédé selon l'une des revendications 1 à 9, comprenant-une bobine (11) selon l'une des revendications 10 à 13, dans lequel le module de capteur (12) comprend d'autres feuilles vertes (1, 3) en plus des deux feuilles vertes (2) de la bobine (11), dans lequel la feuille verte la plus extérieure (3) du module de capteur (12) ne comprend pas de canaux métallisés et/ou de trous métallisés traversants et dans lequel les feuilles vertes (2) de la bobine (11) sont disposées entre les feuilles vertes les plus extérieures (1, 3) du module de capteur (12).

15. Module de capteur selon la revendication 14, dans lequel des trous de connexion (1b, 2c) sont prévus, en particulier dans lequel les trous de connexion (1b, 2c) sont prévus dans au moins une des feuilles vertes (1) qui ne comprennent pas de canaux, dans lequel des plots (4) de la bobine (11), utilisés pour connecter le module de capteur (11) à un circuit électrique (18), sont disposés dans les trous de connexion (1b, 2c) et chaque plot (4) est connecté à une extrémité de l'enroulement de la bobine au moyen de contacts traversants (1b, 2c).

16. Module de capteur selon la revendication 15, dans lequel les plots (4) sont situés sur un côté du module de capteur (12) sur la feuille verte la plus extérieure (1).

17. Module de capteur selon l'une des revendications 14 à 16, dans lequel le module de capteur (12) a un diamètre minimum de 3 mm, en particulier un diamètre de 3,7 mm.

18. Dispositif de capteur (15) pour déterminer la vitesse d'un objet électriquement conducteur (23) passant devant le dispositif de capteur (15), comprenant un boîtier de capteur (16), un module de capteur (12) selon l'une des revendications 14 à 17, dans lequel le module de capteur (12) est disposé à une pointe de capteur (20) du boîtier de capteur (16) et est orienté dans une direction de passage prévue d'un objet électriquement conducteur (23), dans lequel le module de capteur (12) est relié à un circuit électrique (18) disposé à l'intérieur du boîtier de capteur (16) pour le traitement de signaux et la transmission de données.

19. Turbocompresseur (22) comprenant une carcasse (24), une roue de compresseur (25) avec des aubes de roue de compresseur (23), en particulier en matériau électriquement conducteur, notamment en titane, en nickel ou en aluminium, et un dispositif de capteur (15) selon la revendication 18, dans lequel la pointe de capteur (20) du dispositif de capteur (15) est orientée vers les aubes de roue de compresseur (23).

20. Turbocompresseur selon la revendication 19, dans lequel l'épaisseur des aubes de roue de compresseur (23) est égale ou supérieure à 0,2 mm.

21. Utilisation du dispositif de capteur (15) selon la revendication 18 comme capteur de vitesse pour les turbocompresseurs de véhicules, en particulier les véhicules tout-terrain ou les voitures particulières ou les poids lourds, ou pour les turbines d'avion ou pour les turbines génératrices de courant ou pour les machines de forage.
